# EUROPEAN PATENT SPECIFICATION

(11) **EP 0 366 321 B1**
(45) Date of publication and mention of the grant of the patent: **07.02.1996**
(21) Application number: 89310598.1
(22) Date of filing: 16.10.1989
(51) Int. Cl.: G03F 7/32

(54) **Development of radiation sensitive compositions**
Entwickler für Strahlungsempfindliche Zusammensetzungen
Développement de compositions photosensibles

(30) Priority: 24.10.1988 GB 8824841; 10.03.1989 GB 8905577; 21.07.1989 GB 8916717
(43) Date of publication of application: 02.05.1990
(73) Proprietor: E.I. DU PONT DE NEMOURS & COMPANY INCORPORATED, Wilmington Delaware 19898 (US)
(72) Inventor: Ingham, Michael, Nr. Tadcaster North Yorkshire (GB); Styan, Paul Anthony, Garforth Leeds LS25 2BP (GB)
(74) Representative: Overbury, Richard Douglas

(56) References cited:
- EP-A- 0 099 003
- EP-A- 0 180 122
- EP-A- 0 279 164
- GB-A- 2 110 401

## Description

This invention relates to the development of radiation-sensitive compositions and is concerned with the development of such compositions as are used for the production of printing plates and photoresists.

In the production of printing plates and photoresists, a radiation sensitive composition is coated onto a substrate to form a radiation sensitive plate which is then image-wise exposed to radiation so as to selectively expose different areas of the coating. The radiation struck areas and non-radiation struck areas have differing solubility in developer liquids and thus the more soluble areas can be selectively removed from the substrate by the application of a suitable developer liquid to leave an image on the substrate constituted by the less soluble areas.

Radiation sensitive compositions are usually classified as being either positive-working or negative-working. Positive-working compositions have the property of becoming more soluble in a given developer liquid when exposed to radiation whereas negative-working compositions have the property of becoming less soluble.

This difference has meant that in the past, the developer liquids used for the two classes of composition have been substantially different. In particular, negative-working compositions have generally required a developer liquid comprising a substantial proportion of an organic solvent. Thus a developer liquid suitable for positive-working compositions would not develop a negative-working composition and a developer liquid suitable for a negative-working composition would over develop a positive-working composition.

It is an object of the present invention to provide a developer liquid suitable for use in developing both positive and negative-working compositions.

According to one aspect of the present invention there is provided a method of developing an image-wise exposed radiation sensitive composition which comprises the step of contacting the composition with a developer liquid comprising an alkaline silicate, an ethyl hexyl sulphate and a surface active agent.

According to another aspect of the present invention there is provided a developer liquid suitable for developing both positive- and negative- working radiation sensitive compositions after image-wise exposure which developer liquid comprises an alkaline silicate, an ethyl hexyl sulphate, and a surface active agent.

The developer liquid can be used with either positive-working compositions such as compositions comprising a quinone diazide and an alkali soluble resin, compositions comprising a diazo ester and a novolak resin, and compositions comprising a novolak ester or negative-working compositions such as compositions comprising a diazo compound containing groups having the structure 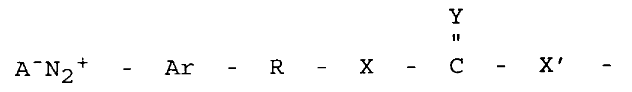 in which Ar represents a divalent or other polyvalent radical derived from an aromatic or heteroaromatic compound; X and X' which may be the same or different, each represents O, S or an imino group, provided that at least one of X and X' is an imino group; Y represents O or S; R represents a single bond or a divalent or other polyvalent radical; and A⁻ is an anion (as described in EP-A-0030862 which is herein incorporated by reference), compositions comprising at least one photoinitiator and at least one photopolymerisable compound which is an acrylic or methacrylic ester of a tetra functional polyol having the general formula:

C(CH₂O)₄(C₃H₆O)ₙ H₄

wherein the average degree of propoxylation n is from 3 to 6, from 50% to 90% of the available hydroxy groups have been converted to acrylate or methacrylate groups, and the remaining hydroxy groups have been reacted with a di-isocyanate or a polyisocyanate (as described in EP-A-0260823 which is herein incorporated by reference), compositions comprising a thioxanthone sensitiser and a light sensitive polymer having pendant dimethyl maleimide groups, compositions comprising supported diazodiphenylamine/formaldehyde condensate, and compositions comprising trimethylolethane triacrylate and a methyl methacrylate/methacrylic acid copolymer as binder.

The developer liquid is particularly suitable for use in machines for automatically developing radiation sensitive plates including such compositions. Generally, the developer liquid can be used in any processor designed for developing positive-working plates. The useful life of the developer liquid will depend on the manner in which the development section of the processor is constructed. Processors having fully enclosed development tanks will give greater bath life due to restricted contact of the developer liquid with the atmosphere. The activity of the developer liquid can be maintained by replenishment and monitored by determining its conductivity as described in EP-A-0107454.

The alkaline silicate is the primary developing agent for positive-working compositions and its concentration determines the degree of development and the useful life of the developer liquid. The alkaline silicate is preferably sodium metasilicate. In the latter case, the sodium metasilicate concentration will generally be from 4 to 20w/v% (40 to 200 g/l) and preferably from 7 to 12 w/v% (70 to 120 g/l).

The ethyl hexyl sulphate acts as a developing aid for negative working compositions and is preferably in the form of the sodium salt. However, other salts may be used. Generally its concentration will be from 2 to 20% by vol, preferably from 3 to 5% by vol, of a 40w/v% solution (i.e. from 8 to 80 g/l, preferably 12 to 20 g/l).

The surface active agent prevents overdevelopment of positive working compositions and may be a non-ionic surfactant such as a polyoxyethylene lauryl ether or an ethylene oxide/propylene oxide condensate of poly(ethylene) glycol. The latter is preferred since it also prevents soiling deposits being formed on the plate surface when developing radiation sensitive plates in some automatic plate processors using hard water in their plate washing section. Generally the surface active agent will be present in an amount of from 0.075% to 1.5% by vol (0.75 to 15.00 ml/litre), preferably from 0.2 to 0.5% by vol (2 to 5 ml/litre).

In an embodiment, the developer additionally includes a water soluble salt of an aliphatic carboxylic acid. This may be the potassium or sodium salt of an acid containing 1-9 carbon atoms, preferably octanoic acid. It acts as a developing aid for both positive and negative-working compositions. The use of sodium octanoate is preferred. The water soluble salt will generally be present in an amount of from 1% to 20% by vol, preferably from 2% to 6% by vol, of a 40% w/v solution (i.e. from 4 to 80g/l, preferably 8 to 24 g/l).

In an embodiment, the developer additionally includes up to 100 g/l of the sodium salt of ethylene diamine tetraacetic acid. This has the advantage of complexing calcium and magnesium ions present in the wash water to prevent the formation of hard water salts. It will generally be present in an amount of from .2% to 10.0 w/v% (2 to 100 g/l), preferably 1 to 3 w/v% (10 to 30 g/l).

### The following Examples illustrate the invention

### EXAMPLE 1

A series of positive-working pre-sensitised plates consisting of a grained and anodised aluminium substrate coated with a composition based on a quinone diazide and an alkali soluble novolak resin were exposed in a printing down frame beneath a continuous tone step-wedge.

The plates were then processed in a Howson-Algraphy Positive Plate Processor containing in the developer section a developer solution having the formulation:-

| | |
|---|---|
| Sodium metasilicate | 3.5Kg |
| Brij 30 | 0.25L |
| Rewopol NEHS-40 | 5L |
| Sodium octanoate | |
| Solution (40% w/v) | 5L |
| Nervanaid BConc. | 1.0 Kg |
| Water to | 50L |

Rewopol NEHS-40 is a 40% w/v solution of the sodium salt of 2-ethyl hexyl sulphate (n - ethyl hexyl sulphate) produced by Rewo Chemicals Ltd, Nervanaid B Conc is the sodium salt of ethylene diamine tetraacetic acid (ABM Chemicals Ltd), and Brij 30 (I.C.I.) is a polyoxyethylene lauryl ether.

There was no sign of the plate being over developed.

### EXAMPLE 2

A series of negative-working plates were made according to Example 1 of European Patent Specification No.0030862 and were exposed and processed in the same way as the plate of Example 1. The plates developed cleanly.

### EXAMPLE 3

Example 2 was repeated except that plates made according to Example 1 of European Patent Specification No.0260823 were used.

Similar results were obtained.

### EXAMPLES 4 TO 6

Examples 1 to 3 were repeated using, as the developer, the following composition:-

| | |
|---|---|
| Nervanaid B Conc | 0.25 Kg |
| Sodium metasilicate | 3.50 Kg |
| Sodium octanoate (40 %) | 2.50L |
| Rewopol NEHS 40 | 5.00L |
| Brij 30 | 0.25L |
| Water to | 50L |

Similar results were obtained in each case.

### EXAMPLE 7

Examples 1 to 3 were repeated using as the developer, the following composition:-

| | |
|---|---|
| Nervanaid B conc | 20KG |
| Sodium metasilicate (5H₂O) | 70Kg |
| Sodium octanoate (40%) | 100L |
| Rewopol NEHS 40 | 100L |
| Supronic B10 | 2L |
| Demineralised water to | 1000L |

Supronic B10 is an ethylene oxide/propylene oxide copolymer of poly(ethylene glycol).

Similar results were obtained in each case.

### EXAMPLE 8

Examples 1 to 3 were repeated using as the developer the following composition:-

| | |
|---|---|
| Nervanaid B conc. | 20KG |
| Sodium metasilicate (5H₂O) | 70Kg |
| Sodium octanoate (40%) | 100L |
| Rewopol NEHS 40 | 100L |
| Supronic B10 | 0.75L |
| Demineralised water to | 1000L. |

Similar results were obtained in each case.

### EXAMPLE 9

The following developer formulation was used in an Autopos automatic plate processor to develop an image-wise exposed Super Amazon Plate (Howson-Algraphy) including a positive working radiation sensitive composition based on a diazo ester and a novolak resin:-

| | |
|---|---|
| Sodium metasilicate | 70KG |
| Brij 30 | 5L |
| Rewopol NEHS40 | 100L |
| Sodium octanoate (40% sol) | 100L |
| Nervanaid B conc | 20Kg |
| Demineralised water to | 1000L |

The plate developed cleanly with no sign of over-development.

Similar results were obtained using a Super Spartan Plate (Howson-Algraphy) and a Triton Plate (Howson-Algraphy) which are similarly based on positive working diazo ester/novolak compositions.

### EXAMPLE 10

The above formulation was used to develop negative-working AQ2 and AQ3 plates (Howson-Algraphy) including radiation sensitive compositions based on a diazo resin and binder.
The plates developed cleanly with no residual coating.

### EXAMPLES 11 to 15

Examples 9 and 10 were repeated using the following developer formulations:

| | EX11 | EX12 | EX13 | EX14 | EX15 |
|---|---|---|---|---|---|
| Sodium Metasilicate | 70Kg | 40Kg | 70Kg | 70Kg | 70Kg |
| Brij 30 | 15L | 5L | 5L | 5L | 5L |
| Rewopol NEHS-40 | 100L | 100L | 50L | 100L | 100L |
| Sodium Octanoate (40% sol) | 100L | 100L | 100L | 50L | 100L |
| Nervanaid B Conc | 20Kg | 20Kg | 20Kg | 20Kg | 40Kg |
| Demineralised Water to | 1000L | 1000L | 1000L | 1000L | 1000L |

In each case, the plates developed cleanly.

### EXAMPLES 16 AND 17

Examples 9 and 10 were repeated using the following developer formulations:-

| | EX16 | EX17 |
|---|---|---|
| Sodium Metasilicate | 70Kg | 70Kg |

| | EX16 | EX17 |
|---|---|---|
| Supronic B10 | 0.75L | 2L |
| Rewopol NEHS-40 | 100L | 100L |
| Sodium Octanoate (40% sol) | 100L | 100L |
| Nervanaid B Conc | 20Kg | 20Kg |
| Demineralised water to | 1000 L | 1000 L |

The plates developed cleanly in each case.

### EXAMPLE 17

Example 9 was repeated using commercially available positive working plates viz New Capricorn (Horsell) including a radiation sensitive composition based on novolak ester, P61 (Hoechst) including a radiation sensitive composition based on a diazo ester and novolak resin and Nylolith PMS (BASF) including a radiation sensitive composition based on a novolak ester. These plates processed cleanly with no over-development.

### EXAMPLE 18

Example 9 was repeated using Nylolith NL (a commercially available negative working plate of BASF including a radiation sensitive composition based on a supported diazo system). It developed cleanly.

### EXAMPLE 19

The developer formulation of Example 9 was used in an NP60 processor (Horsell) to develop AQ3, Super Amazon and Super Spartan plates and was used in a VA6 processor (Hoechst) to develop AQ3 and Super Amazon plates and an Ultrapos (Horsell) plate including a radiation sensitive composition based on a novolak ester. In all cases it was found to develop both negative and positive plates cleanly.

## Claims

1. A method of developing an image-wise exposed radiation sensitive composition which comprises the step of contacting the composition with a developer liquid comprising an alkaline silicate, an ethyl hexyl sulphate and a surface active agent.

2. A method according to claim 1 wherein the composition is a positive working composition.

3. A method according to claim 2 wherein the composition comprises a quinone diazide and an alkali soluble resin.

4. A method according to claim 1 wherein the composition is a negative working composition.

5. A method according to claim 4 wherein the composition comprises a diazo compound containing groups having the structure 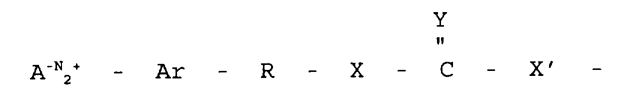 in which Ar represents a divalent or other polyvalent radical derived from an aromatic or heteroaromatic compound; X and X' which may be the same or different, each represents O, S or an imino group, provided that at least one of X and X' is an imino group; Y represents O or S; R represents a single bond or a divalent or other polyvalent radical; and A⁻ is an anion.

6. A method according to claim 4 wherein the composition comprises at least one photoinitiator and at least one photopolymerisable compound which is an acrylic or methacrylic ester of a tetra functional polyol having the general formula:
C(CH₂O)₄(C₃H₆O)ₙ H₄
wherein the average degree of propoxylation n is from 3 to 6, from 50% to 90% of the available hydroxy groups have been converted to acrylate or methacrylate groups, and the remaining hydroxy groups have been reacted with a di-isocyanate or a polyisocyanate.

7. A method according to any preceding claim wherein the radiation sensitive composition is in the form of a coating on a substrate.

8. A developer liquid suitable for developing both positive- and negative-working radiation sensitive compositions after image-wise exposure which developer liquid comprises an alkaline silicate, an ethyl hexyl sulphate, and a surface active agent.

9. A developer liquid as claimed in claim 8 wherein the alkaline silicate is sodium metasilicate.

10. A developer liquid as claimed in claim 8 or 9 wherein the surface active agent is a polyoxyethylene lauryl ether or an ethylene oxide/propylene oxide condensate of poly(ethylene) glycol.

11. A developer liquid as claimed in claim 8, 9 or 10 which additionally includes a water soluble salt of an aliphatic carboxylic acid.

12. A developer liquid as claimed in claim 11 wherein the water soluble salt is the sodium or potassium salt of an acid containing 1 to 9 carbon atoms.

13. A developer liquid as claimed in claim 12 wherein the acid is octanoic acid.

14. A developer liquid as claimed in any one of claims 8 to 13 which additionally includes the sodium salt of ethylene diamine tetra acetic acid.

15. A developer liquid as claimed in claim 8 comprising from 40 to 200 g/l of sodium metasilicate, from 0.75 to 15.00 ml/l of surface active agent, from 4 to 80 g/l of sodium octanoate, from 8 to 80 g/l of sodium ethyl hexyl sulphate, and up to 100 g/l of the sodium salt of ethylene diamine tetra acetic acid.

## Patentansprüche

1. Verfahren zum Entwickeln einer bildweise exponierten strahlenempfindlichen Zusammensetzung, enthaltend den Schritt des in Berührungbringens der Zusammensetzung mit einer Entwicklerflüssigkeit, welche ein Alkalisilikat, ein Äthylhexylsulfat und ein oberflächenaktives Agens enthält.

2. Verfahren nach Anspruch 1, bei welchem die Zusammensetzung eine positiv arbeitende Zusammensetzung ist.

3. Verfahren nach Anspruch 2, bei welchem die zusammensetzung ein Chinondiazid und ein alkalilösliches Harz enthält.

4. Verfahren nach Anspruch 1, bei welchem die Zusammensetzung eine negativ arbeitende Zusammensetzung ist.

5. Verfahren nach Anspruch 4, bei welchem die Zusammensetzung eine Diazoverbindung mit Gruppen folgender Struktur enthält: 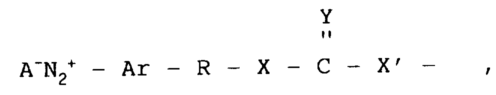 in welcher Ar ein bivalentes oder sonstiges polyvalentes Radikal darstellt, welches von einer aromatischen oder heteroaromatischen Verbindung abgeleitet ist; X und X', welche gleich oder unterschiedlich sein können, O, S oder eine Imino-Gruppe darstellen, vorausgesetzt, daß wenigstens eines der X und X' eine Imino-Gruppe ist; Y O oder S darstellt; R ein einfachbindendes, bivalentes oder sonstiges polyvalentes Radikal darstellt; und A⁻ ein Anion ist.

6. Verfahren nach Anspruch 4, bei welchem die Zusammensetzung wenigstens einen Fotoinitiator und wenigstens eine fotopolimerisierbare Verbindung enthält, welche ein Acryl- oder Methacrylester eines tetra-funktionnalen Polyol ist mit der allgemeinen Formel:
C(CH₂O)₄(C₃H₆O)ₙ H₄ ,
in welcher der mittlere Grad der Propoxylation n von 3 bis 6 erreicht, von 50 bis 90% der zugänglichen Hydroxy-Gruppen in Acrylat- oder Methacrylat-Gruppen umgewandelt worden sind, und die restlichen Hydroxy-Gruppen mit einem Di-Isocyanat oder einem Polysocyanat reagiert haben.

7. Verfahren nach einem der vorhergehenden Ansprüche, bei welchem die strahlenempfindliche Zusammensetzung in Form eines Überzuges eines Trägers vorliegt.

8. Entwicklerflüssigkeit für die Entwicklung sowohl positiv als auch negativ arbeitender strahlenempflindlicher Zusammensetzung nach einer bildweisen Exposition, enthaltend ein Alkalisilikat, ein Äthylhexylsulfat und ein oberflächenaktives Agens.

9. Entwicklerflüssigkeit nach Anspruch 8, bei welcher das Alkalisilikat ein Natrium-Methasilikat ist.

10. Entwicklerflüssigkeit nach Anspruch 8 oder 9, bei welchem das oberflächenaktive Agens ein Polyoxyäthylenlauryläther oder ein Äthylenoxyd/Propylenoxyd-Kondensat von Poly(äthylen)glycol ist.

11. Entwicklerflüssigkeit nach einem der Ansprüche 8, 9 oder 10, welche zusätzlich ein wasserlösliches Salz einer aliphatischen Carboxylsäure aufweist.

12. Entwicklerflüssigkeit nach Anspruch 11, bei welcher das wasserlösliche Salz ein Natrium- oder Kaliumsalz einer Säure ist, welche 1 bis 9 Kohlenstoff-Atome enthält.

13. Entwicklerflüssigkeit nach Anspruch 12, bei welcher die Säure Octhylsäure ist.

14. Entwicklerflüssigkeit nach einem der Ansprüche 8 bis 13, welche zusätzlich das Natriumsalz der Äthylendiamintetraessigsäure enthält.

15. Entwicklerflüssigkeit nach Anspruch 8 enthaltend von 40 bis 200 g/l Natrium-Methasilikat, von 0,75 bis 15,00 m/l oberflächenaktives Agens, von 4 bis 80 g/l Natrium-Octhylat, von 8 bis 80 g/l Natrium-Äthylhexylsulfat, und bis zu 100 g/l des Natriumsalzes der Äthylendiamintetraessigsäure.

## Revendications

1. Procédé de développement d'une composition sensible à l'irradiation, exposée de manière à former une image, qui comprend l'étape consistant à mettre en contact la composition avec un agent de développement liquide comprenant un silicate alcalin, un sulfate d'éthylhexyle et un agent tensioactif.

2. Procédé selon la revendication 1, dans lequel la composition est une composition positive.

3. Procédé selon la revendication 2, dans lequel la composition comprend un diazoture de quinone et une résine soluble dans les alcalis.

4. Procédé selon la revendication 1, dans lequel la composition est une composition négative.

5. Procédé selon la revendication 4, dans lequel la composition comprend un composé diazoïque contenant des groupes ayant la structure 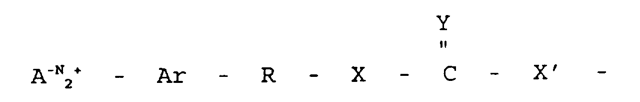 dans laquelle Ar représente un radical divalent ou autre polyvalent dérivé d'un composé aromatique ou hétéroaromatique ; X et X', qui peuvent être identiques ou différents, représentent chacun O, S ou un groupe imino, étant entendu qu'au moins l'un de X et X' est un groupe imino ; Y représente O ou S ; R représente une liaison simple ou un radical divalent ou autre polyvalent; et A' est un anion.

6. Procédé selon la revendication 4, dans lequel la composition comprend au moins un photoamorceur et au moins un composé photopolymérisable qui est un ester acrylique ou méthacrylique d'un polyol tétrafonctionnel répondant à la formule générale :
C(CH₂O)₄(C₃H₆O)ₙ H₄
dans laquelle le degré moyen de propoxylation n est de 3 à 6, de 50 % à 90 % des groupes hydroxy disponibles ayant été convertis en groupes acrylate ou méthacrylate, et les groupes hydroxy restants ayant été mis à réagir avec un diisocyanate ou un polyisocyanate.

7. Procédé selon l'une quelconque des revendications précédentes, dans lequel la composition sensible à l'irradiation est sous la forme d'un revêtement porté par un substrat.

8. Agent de développement liquide approprié pour développer des compositions sensibles à l'irradiation aussi bien positives que négatives, après exposition de manière à former une image, ledit agent de développement liquide comprenant un silicate alcalin, un sulfate d'éthylhexyle et un agent tensioactif.

9. Agent de développement liquide selon la revendication 8, dans lequel le silicate alcalin est du métasilicate de sodium.

10. Agent de développement liquide selon la revendication 8 ou 9, dans lequel l'agent tensioactif est un polyoxyéthylène-lauryl éther ou un condensat oxyde d'éthylène/oxyde de propylène de poly(éthylène)glycol.

11. Agent de développement liquide selon la revendication 8, 9 ou 10, qui comprend en outre un sel hydrosoluble d'un acide carboxylique aliphatique.

12. Agent de développement liquide selon la revendication 11, dans lequel le sel hydrosoluble est le sel de sodium ou de potassium d'un acide contenant 1 à 9 atomes de carbone.

13. Agent de développement liquide selon la revendication 12, dans lequel l'acide est l'acide octanoïque.

14. Agent de développement liquide selon l'une quelconque des revendications 8 à 13, qui comprend en outre le sel de sodium de l'acide éthylènediaminetétraacétique.

15. Agent de développement liquide selon la revendication 8, comprenant de 40 à 200 g/l de métasilicate de sodium, de 0,75 à 15,00 ml/l d'agent tensioactif, de 4 à 80g/l d'octanoate de sodium, de 8 à 80g/l d'éthylhexylsulfate de sodium, et jusqu'à 100 g/l du sel de sodium de l'acide éthylènediaminetétraacétique.
